# EUROPEAN PATENT APPLICATION

(11) **EP 4 822 360 A1**
(43) Date of publication of application: **14.10.2026**
(21) Application number: 26169344.4
(22) Date of filing: 30.03.2026
(51) Int. Cl.: G01R 19/25

(54) **SYSTEMS AND METHODS FOR ENHANCEMENT OF DIGITALLY SAMPLED ELECTRICAL MEASUREMENTS**

(30) Priority: 01.04.2025 US 202563781826 P; 19.08.2025 US 202519303519
(71) Applicant: Schweitzer Engineering Laboratories, Inc., Pullman, WA 99163 (US)
(72) Inventor: West, Isaac, Moscow (US)
(74) Representative: Smith, Jeremy Robert

(57) **Abstract**

Systems, methods, and devices are provided to condition digital samples of an electric power delivery system to identify power quality. An intelligent electronic device (IED) for an electric power delivery system may include analog front-end hardware to receive current and voltage measurements of the electric power delivery system, sampling circuitry to digitally sample the current and voltage measurements according to a first clock, a first resampling component to perform linear interpolation on the initial digital samples according to a second clock, a second resampling component to perform quadratic interpolation on the resampled digital samples, and one or more compensation filters to compensate for linear interpolation error or quadratic interpolation error, or both.

## Description

### BACKGROUND

This disclosure relates to systems and methods for digital signal processing to compensate for gain errors induced by interpolation of digitally sampled electrical measurements.

Electric power delivery systems carry electricity from a transmission system to residential communities, factories, industrial areas, and other electricity consumers. An electric power delivery system may include various intelligent electronic devices (IEDs) that may obtain measurements of electrical properties of the electric power delivery system. Based on the electrical measurements, the IED may perform a control function, such as to control a circuit breaker. One measurement is referred to as power quality. To identify power quality under certain standards, such as IEC 61000-4-30, many higher order harmonics may be determined. Many IEDs may apply time-alignment of sampled data for measurements that require time accuracy, such as synchrophasors or oscillography event recordings. As such, interpolation between samples may be used. Yet digitally sampled electrical measurements may suffer from distortion due to errors in interpolation, particularly at higher-order harmonics. One solution is to redesign the front-end hardware and analog-to-digital conversion (ADC) circuitry, but this may be complex and expensive. What is more, while redesigning front-end hardware and ADC circuitry may work for new IEDs, there are numerous IEDs in the field that would not be able to benefit from such improvements.

### BRIEF DESCRIPTION OF THE DRAWINGS

FIG. 1 is a schematic diagram of an electric power delivery system;
FIG. 2 is a block diagram of an IED of an electric power delivery system to perform filtering to expand sampling bandwidth to enable measuring harmonics at frequencies higher than the sampling frequency;
FIG. 3 is a plot illustrating a worst-case interpolation error that may occur using linear interpolation;
FIG. 4 is a plot of linear interpolation error at 16.7% of the sampling rate;
FIG. 5 is a plot of worst-case linear interpolation frequency response;
FIG. 6 is a block diagram of a quadratic interpolation compensation filter (QIF) including gain compensation and low-pass filtering;
FIG. 7 is a set of plots of gain response of the gain compensation filters to ameliorate error due to linear interpolation for voltage and current channels in comparison to nominal channels without the compensation;
FIG. 8 is a plot of the frequency response of the low pass filter in decibels;
FIG. 9 is a plot of quadratic interpolation and linear interpolation error at 16.7% of the sampling rate;
FIG. 10 is a plot of worst-case quadratic interpolation and linear interpolation frequency response;
FIG. 11 is a plot of the averaged absolute gain frequency response of a quadratic interpolation compensation filter;
FIG. 12 is a plot of the averaged absolute gain frequency response of the quadratic interpolation compensation filter in combination with the low pass filter; and
FIG. 13 is a set of plots of the averaged absolute gain frequency response on the voltage channel and current channel.

### DETAILED DESCRIPTION

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be noted that references to "one embodiment" or "an embodiment" of the present disclosure are not intended to be interpreted as excluding the existence of additional embodiments that also incorporate the recited features. Furthermore, the phrase A "based on" B is intended to mean that A is at least partially based on B. Moreover, unless expressly stated otherwise, the term "or" is intended to be inclusive (e.g., logical OR) and not exclusive (e.g., logical XOR). In other words, the phrase "A or B" is intended to mean A, B, or both A and B.

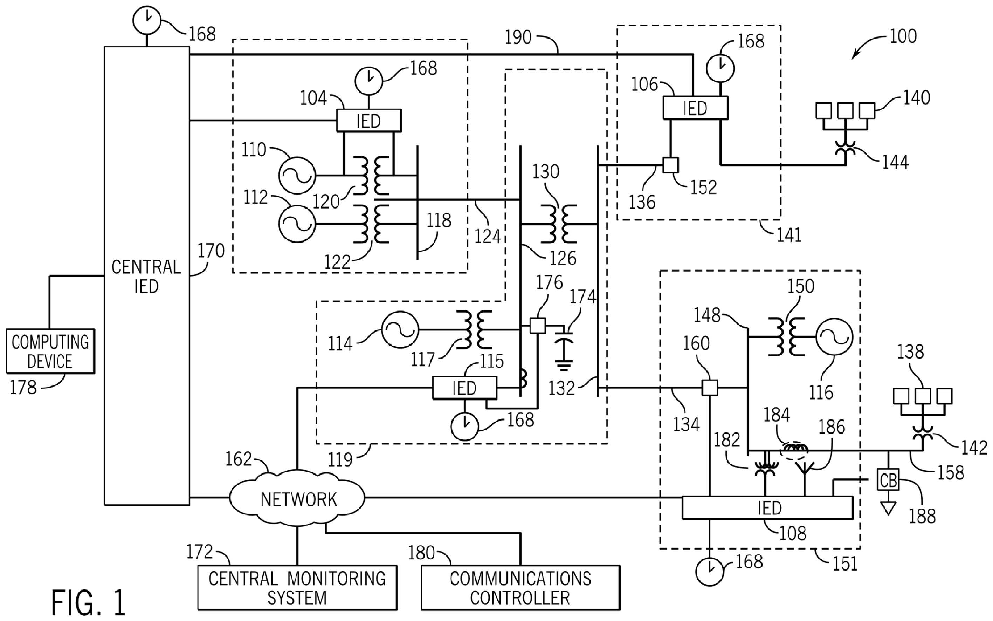

FIG. 1 is a schematic diagram of an electric power delivery system 100 that may generate, transmit, and/or distribute electric energy to various loads (e.g., different structures). The electric power delivery system 100 may use various IEDs 104, 106, 108, 115, 204 to control certain aspects of the electric power delivery system 100. As used herein, an IED (e.g., the IEDs 104, 106, 108, 115, 204) may refer to any processing-based device that monitors, controls, automates, and/or protects monitored equipment within the electric power delivery system 100. Although the present disclosure primarily discusses the IEDs 104, 106, 108, 115, 204 as relays, such as a remote terminal unit, a differential relay, a distance relay, a directional relay, a feeder relay, an overcurrent relay, a voltage regulator control, a voltage relay, a breaker failure relay, a generator relay, and/or a motor relay, additional IEDs 104, 106, 108, 115, 204 may include an automation controller, a bay controller, a meter, a recloser controller, a communications processor, a computing platform, a programmable logic controller (PLC), a programmable automation controller, an input and output component, and the like. Moreover, the term IED may be used to describe an individual IED or a system including multiple IEDs.

For example, the electric power delivery system 100 may be monitored, controlled, automated, and/or protected using the IEDs 104, 106, 108, 115, 204 and a central monitoring system 172 (e.g., an industrial control system). In general, the IEDs 104, 106, 108, 115, 204 may be used for protection, control, automation, and/or monitoring of equipment in the electric power delivery system 100. For example, the IEDs 104, 106, 108, 115, 204 may be used to monitor equipment of many types, including electric power lines, current sensors, busses, switches, circuit breakers, reclosers, transformers, autotransformers, tap changers, voltage regulators, capacitor banks, generators, motors, pumps, compressors, valves, and a variety of other suitable types of monitored equipment.

A common time signal may be distributed throughout the electric power delivery system 100. Utilizing a common time source may ensure that IEDs 104, 106, 108, 115, 204 have a synchronized time signal that can be used to generate time synchronized data, such as synchrophasors. In various embodiments, the IEDs 104, 106, 108, 115, 204 may receive a common time signal 168. The time signal may be distributed in the electric power delivery system 100 using a communications network 162 and/or using separate connections to a common time source, such as a Global Navigation Satellite System ("GNSS"), or the like.

The IEDs 104, 106, 108, 115, 204 may be used for controlling various other equipment of the electric power delivery system 100. By way of example, the illustrated electric power delivery system 100 includes electric generators 110, 112, 114, 116, power transformers 117, 120, 122, 130, 142, 144, 150, a potential transformer 213, and a current transformer 212. The electric power delivery system 100 may also include electric power lines 124, 134, 136, 158 and/or busses 118, 126, 132, 148 to transmit and/or deliver power, communications lines 190 to transmit communications, circuit breakers 152, 160, 176 to control flow of power in the electric power delivery system 100, and/or loads 138, 140 to receive the power in and/or from the electric power delivery system 100. A variety of other types of equipment may also be included in electric power delivery system 100, such as a voltage regulator, a capacitor (e.g., a capacitor 174), a potential transformer (e.g., a potential transformer 182), a current sensor (e.g., a wireless current sensor (WCS) 184), an antenna (e.g., an antenna 186), a capacitor banks (e.g., a capacitor bank (CB) 188), and other suitable types of equipment useful in power generation, transmission, and/or distribution.

A substation 119 may include the electric generator 114, which may be a distributed generator and which may be connected to the bus 126 through the power transformer 117 (e.g., a step-up transformer). The bus 126 may be connected to the distribution bus 132 via the power transformer 130 (e.g., a step-down transformer). Various electric power lines 136, 134 may be connected to the distribution bus 132. The electric power line 136 may lead to a substation 141 in which the electric power line 136 is monitored and/or controlled using the IED 106, which may selectively open and close the circuit breaker 152. The load 140 may be fed from the electric power line 136, and the power transformer 144 (e.g., a step-down transformer) in communication with the distribution bus 132 via electric power line 136 may be used to step down a voltage for consumption by the load 140. The power line 136 may also be monitored by the IED 204 connected to the potential transformer 213 and the current transformer 212.

The electric power line 134 may deliver electric power to the bus 148 of the substation 151. The bus 148 may also receive electric power from the distributed electric generator 116 via the power transformer 150. The electric power line 158 may deliver electric power from the bus 148 to the load 138 and may include the power transformer 142 (e.g., a step-down transformer). The circuit breaker 160 may be used to selectively connect the bus 148 to the electric power line 134. The IED 108 may be used to monitor and/or control the circuit breaker 160 as well as the electric power line 158.

According to various embodiments, the central monitoring system 172 may include one or more of a variety of types of systems. For example, the central monitoring system 172 may include a supervisory control and data acquisition (SCADA) system and/or a wide area control and situational awareness (WACSA) system. A central IED 170 may be in communication with the IEDs 104, 106, 108, 115, 204 via the communications line 190. The IEDs 104, 106, 108, 115, 204 may be remote from the central IED 170 and may communicate over various media. For instance, the central IED 170 may be directly in communication with the IEDs 104, 106 and may be in communication with the IEDs 108, 115, 204 via the communications network 162.

The central IED 170 may enable or block data flow between any of the IEDs 104, 106, 108, 115, 204. For example, during operation of the electric power delivery system 100, the IEDs 104, 106, 108, 115, 204 may transmit data with one another to perform various functionalities for the electric power delivery system 100 by initially transmitting the data to the central IED 170. The central IED 170 may receive the data and may subsequently transmit the data to an intended recipient of the data. The central IED 170 may also control data flow between one of the IEDs 104, 106, 108, 115, 204 and another device communicatively coupled to the central IED 170, such as a computing device 178. For instance, the computing device 178 may be a laptop, a mobile phone, a desktop, a tablet, or another suitable device with which a user (e.g., a technician, an operator) may interact. As such, the user may utilize the computing device 178 to receive data, such as operating data, from the electric power delivery system 100 via the central IED 170 and/or to send data, such as a user input, to the electric power delivery system 100 via the central IED 170. Thus, the central IED 170 may enable or block operation of the electric power delivery system 100 via the computing device 178.

A communications controller 180 may interface with equipment in the communications network 162 to create a network (e.g., ethernet, SDN, etc.) that facilitates communication between the central IED 170, the IEDs 104, 106, 108, 115, 204, and/or the central monitoring system 172. In various embodiments, the communications controller 180 may interface with a control plane (not shown) in the communications network 162. Using the control plane, the communications controller 180 may direct the flow of data within the communications network 162. Indeed, the communications controller 180 may communicate with the central IED 170 to instruct the central IED 170 to transmit certain data (e.g., data associated with a certain set of characteristics or information) to a particular destination (e.g., an intended recipient) using flows, matches, and actions defined by the communications controller 180.

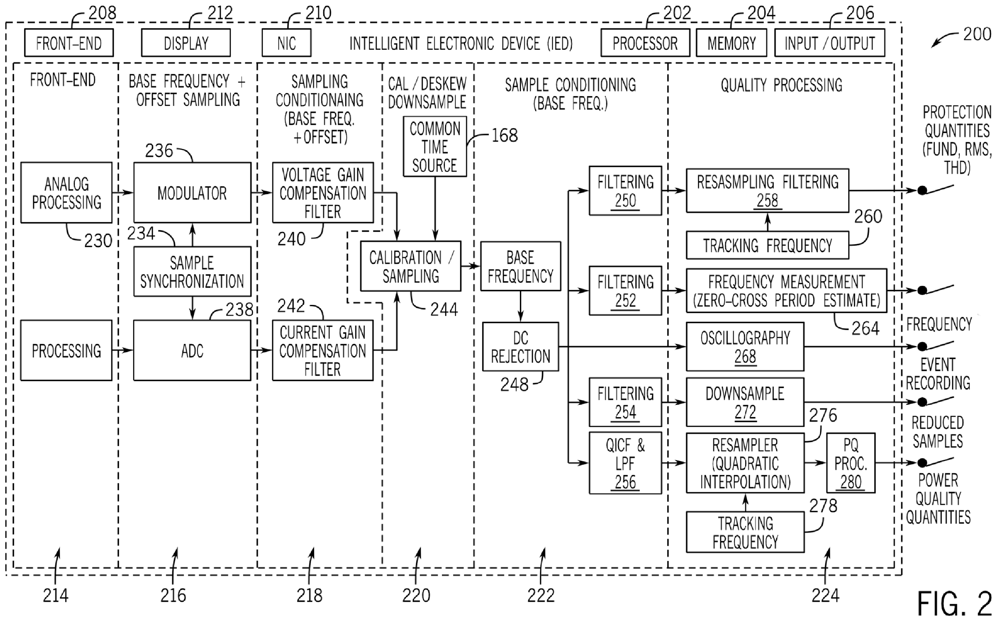

FIG. 2 illustrates an example IED 200 that may obtain a variety of measurements of the electrical power delivery system 100. The IED 200 may be used as any suitable IED, such as the IEDs 104, 106, 108, 115, 204, and/or the central monitoring system 172 shown in FIG. 1. The IED 200 is shown to include data processing circuitry such as a processor 202 and memory 204, input/output circuitry 206, analog front-end hardware 208, network interface (NIC) circuitry 210, and an electronic display 212, though the IED 200 may include more or fewer such components. The processor 202 may execute instructions stored on the memory 204, which may be any suitable tangible, non-transitory, machine-readable media (e.g., random-access memory (RAM), read-only memory (ROM), non-volatile RAM (NVRAM), Flash memory, a hard disk drive (HDD), a solid-state drive (SSD), a compact disc ROM (CD-ROM)). The instructions may enable the IED 200 to carry out various filtering techniques to expand the bandwidth of electrical measurements obtained by the IED 200. The input/output circuitry 206 may include analog inputs and digital inputs and outputs. Analog voltages and currents may be received via the input/output circuitry 206 and processed and digitized by the analog front-end hardware 208. The results may be communicated via the NIC 200 and/or displayed on the electronic display 212. As a result of the measurements, the IED 200 may control various aspects of the electric power delivery system 100 (e.g., the IED 200 may control a breaker or provide a message based on a measurement of the power quality).The following applications include examples of how harmonic measurements may be used in the power system: Digital fault recorders use harmonic measurements to trigger data recording during power system disturbances or other anomalous behavior in the electrical grid. Harmonic measurements indicate valuable information about poor power system performance. Power and industrial plants are often required to report on harmonic performance according to IEEE 2800. Harmonics can induce thermal wear and damage on power system components and must be mitigated. For example, In extremely high voltage, DC transmission systems where inductive and capacitive components are used to filter out high-order harmonics from bridge rectifiers, higher-order harmonics generate extra heat that can damage the components. Harmonic measurements may be used to integrate with thermal elements to protect the components from thermal damage.

In some cases, the front-end hardware 208 may not be designed to measure electrical voltage and current of the electric power delivery system 100 for power quality (PQ) measurements, particularly higher order harmonics. Sampling bandwidth and interpolation methods may impede the measurement performance of the front-end hardware 208. Yet in spite of these challenges, the IED 200 may perform signal processing techniques that may result in a measure of PQ in compliance with the International Electrotechnical Commission (IEC) 61000-4-30 standard.

As shown in FIG. 2, the IED 200 may perform signal processing in various stages, including a front-end stage 214, a sampling stage 216, a first digital sample conditioning stage 218, a calibration / deskew stage 220, a second digital sample conditioning stage 222, and a quantity processing stage 224. These stages may be implemented in various components of the IED 200. For example, the front-end stage 214 and the sampling stage 216 may be implemented using the analog front-end hardware 208, whereas the remaining stages may be carried out digitally by the processor 202 executing instructions from the memory 204 or via specialized circuitry to perform digital signal processing (DSP), such as a field programmable gate array (FPGA) programmed with a system design to perform this digital signal processing.

For example, a first input 226 may receive an analog voltage value and a second input 228 may receive an analog current value from a measurement device on the electric power delivery system 100. With respect to the voltage measurement, the front-end stage 214 may entail performing analog processing 230 such as stepping down the voltage (e.g., using the front-end hardware 208 of the IED 200 or a separate potential transformer (PT) external to the IED 200) and applying analog low-pass filtering. With respect to the current measurement, the front-end stage 214 may entail performing analog processing 232 such as transforming the current (e.g., using the front-end hardware 208 of the IED 200 or a separate current transformer (CT) external to the IED 200) and applying analog low-pass filtering.

To digitally sample the analog voltage and current values, in the sampling stage 216, voltage and current digital samples may be obtained in a synchronized manner according to a synchronization component 234. The synchronization component 234 may represent any suitable software component or circuitry that may trigger sampling circuitry such as a delta-sigma modulator 236 and an analog-to-digital converter (ADC) 238 to sample the analog voltage and current signals, respectively, at the same time. The resulting outputs of the delta-sigma modulator 236 and the ADC 238 are digital values that may undergo further processing. Note that the sample synchronization component may operate based on an internal clock of the IED 200. This means that, to calibrate the samples based on the common time source 168 used by other IEDs, the digital samples will be resampled before they are used by the IED 200 or other IEDs.

To counteract some of the effects of linear interpolation, which will be used in resampling to the common time source 168, the synchronization component 234 may trigger the delta-sigma modulator 236 and an analog-to-digital converter (ADC) 238 at a frequency offset slightly higher than a base frequency of the ultimate measurement that is obtained. Then, when the digital samples are resampled, they may be downsampled to the base frequency. This will effectively average some of the interpolation error. For example, if the base frequency is 24 kHz, the synchronization component 234 may trigger the delta-sigma modulator 236 and an analog-to-digital converter (ADC) 238 at a frequency of 24.1 kHz. The offset value may be any suitable frequency value that enables subsequent processing to resample down to the base frequency to average a linear interpolation error that may occur in the sampling stage 216 (e.g., 0.05 kHz, 0.1 kHz, 0.2 kHz, 0.5 kHz, 1 kHz, 2 kHz, 5 kHz, 10 kHz, 20 kHz). The delta-sigma modulator 236 may also include a low-pass filter, such as a cascaded integrator-comb (CIC) filter.

Once generated, the digital samples may be conditioned in the first digital sample conditioning stage 218. A voltage channel gain compensation filter 240 may compensate for artifacts introduced by the analog front-end hardware 208 on the voltage channel, the delta-sigma modulator 236 (and/or the CIC filter if present), and linear interpolation that will take place in the calibration / deskew stage 220. Likewise, a current channel gain compensation filter 242 may compensate for artifacts introduced by the analog front-end hardware 208 on the current channel, the ADC 238, and linear interpolation that will take place in the calibration / deskew stage 220.

As mentioned above, the sampling stage 216 and the first sample conditioning stage 218 operate on samples obtained at the base frequency plus the offset frequency based on an internal clock of the IED 200. In the calibration / deskew stage 220, the digital samples of voltage and current may be resampled based on the common time source 168 at the base frequency. A calibration / resampling component 244 may resample the incoming digital voltage and current measurements based on the common time source 168 using linear interpolation. Linear interpolation allows the calibration / resampling component 244 to obtain the resampled measurements in a fast, efficient manner. However, as will be discussed below, linear interpolation can also introduce certain errors. Yet the errors introduced by linear interpolation in the calibration / resampling component 244 may be effectively ameliorated with certain filtering operations in the second sample conditioning stage 222 and the quantity processing stage 224.

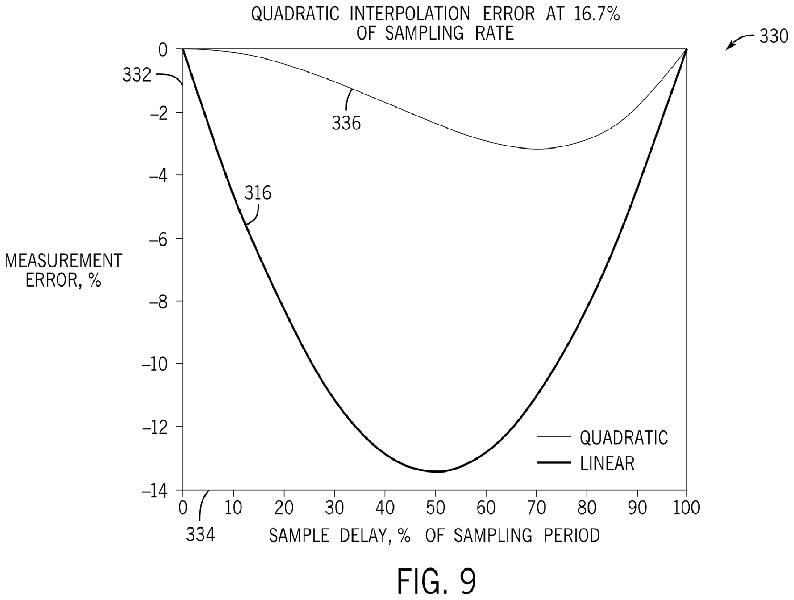

Indeed, in the second sample conditioning stage 222, after performing DC rejection 248, the IED 200 may perform a variety of different filtering operations 250, 252, 254, and a quadratic interpolation compensation filter (QICF) convolved with a low-pass filter (LPF) 256. The filtering operations 250, 252, and 254 and the QICF & LPF 256 may be designed to improve the results of various quantities that the IED 200 may compute. The filtering operations 250, 252, and 254 may improve the results of protective quantities, frequency, and/or reduced samples. The QICF & LPF 256 may improve the results of the power quality (PQ) quantity output by the IED 200 and may effectively expand the bandwidth of the IED 200 with respect to PQ. The QICF 256 may implement a multi-tap (e.g., 100-tap, 125-tap, 155-tap, 180-tap) finite impulse response (FIR) filter to compensate for quadratic interpolation that will take place in the quantity processing stage 224. The number of taps may vary depending on the total number of sample/cycle re-sampling mentioned above and to satisfy Nyquist for downsampling from the base frequency (e.g., from 24 kHz to 12 kHz). Examples of the QICF 256 will be discussed further below with reference to FIGS. 9-12.

In the quantity processing stage 224, the IED 200 may perform resample filtering 258 according to a tracking frequency 260 (e.g., also referred to herein as the target frequency) to generate protection quantities 262 such as fundamental frequency component (Fund), root mean square (RMS), and total harmonic distortion (THD). A frequency estimate based on zero-crossing period estimates 264 may be used to identify a primary frequency 266 of the electric power delivery system 100. Oscillography 268 may be used to generate an event recording 270. Downsampling 272 may be used to generate reduced, downsampled samples 274. Resampling based on quadratic interpolation 276 according to a tracking frequency 278 may provide enhanced samples that may undergo further power quality processing 280 to generate power quality (PQ) quantities 282. The IED 200 may perform the resampling based on quadratic interpolation 276 using any suitable number of samples per cycle (e.g., 64, 128, 256, 512, 1024, 2048, and so on). Quadratic interpolation enables improved accuracy for conditions where the number of samples/cycle sampling rate is at or near an integer division of the base frequency (e.g., a sampling rate of 12 kHz when the base frequency is 24 kHz). The resulting PQ quantities 282 may be in compliance with the IEC 61000-4-30 standard using the improved sampling and filtering operations of this disclosure.

The IED 200 may obtain data acquisition samples with sub-microsecond time alignment and accuracy. To accomplish this, the IED 200 resamples ingress samples to the common time source. Resampling to a new point in time involves estimating the measurement for the desired time using other known values with adjacent timestamps. Depending on the frequency of the input signal and the method used to estimate the sample, significant error can be introduced into the measurement during this process. As such, the IED 200 may employ methods to reduce (e.g., minimize) this error and enhance measurement accuracy at higher order harmonics.

The calibration / deskew component 244 in the IED 200 may use linear interpolation to resample the initially obtained digital samples with sub-microsecond accuracy and top-of-second time-alignment. Linear interpolation works well for lower frequencies but attenuates signal magnitudes at higher frequencies. This resampling method linearly interpolates to the new sample time using the two nearest samples. As the ratio of the sampling rate divided by the frequency of the input signal becomes smaller, linear interpolation becomes less reliable in accurately representing a sinusoidal signal. For example, if the peak of a sinusoidal signal is found exactly between two samples, then the maximum error may arise when interpolating a sample in the measurement of the peak of the input signal. This measurement error increases with increasing frequency in the input signal.

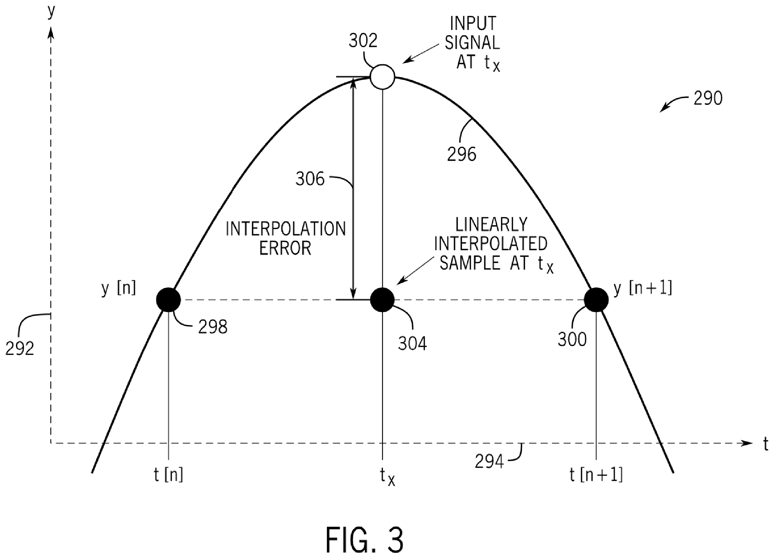

FIG. 3 is a plot 290 of such a worst-case linear-interpolation error that may arise during resampling. An ordinate 292 represents magnitude of the voltage or current and an abscissa 294 represents time. A curve 296 illustrates the actual analog measurement of the current or voltage. A point 298 represents an nth digital sample of the curve 296 obtained at a first time t[n] having a value of y[n], where n is a positive integer. A point 300 represents a next (n+1) digital sample of the curve 296 obtained at a second time t[n+1] having a value of y[n+1]. As mentioned above, the IED 200 obtains digital samples of voltage or current obtained according to the internal clock of the IED 200 and uses the calibration / deskew component 244 to obtain new digital samples according to the common time source 168. During resampling (e.g., in the calibration / deskew stage 220), linear interpolation may be used to estimate the value of a digital sample of the current or voltage at a time intermediate to time t[n] and time t[n+1]. Here, at a time *tₓ*, the actual value of the digital sample that would have been obtained if the analog current or voltage along curve 296 had been measured is shown at a point 302. But in this example, which represents a worst-case scenario of linear interpolation, a point 304 represents the linearly interpolated resampled value at time *tₓ.* The difference between the actual value at the point 302 and the resampled value at the point 304 is the interpolation error 306.

The IED 200 may obtain data acquisition samples with sub-microsecond time alignment and accuracy. To accomplish this, the IED 200 resamples ingress samples to the common time source. Resampling to a new point in time involves estimating the measurement for the desired time using other known values with adjacent timestamps (e.g., the initial digital samples corresponding to the points 298 and 300). Depending on the frequency of the input signal and the method used to estimate the sample, significant error can be introduced into the measurement during this process, as shown by the interpolation error 306. As such, the IED 200 may employ methods to reduce (e.g., minimize) this error and enhance measurement accuracy at higher order harmonics.

This method of linear interpolation can be described in terms of an FIR filter written as: ${H}_{L} \left(z\right) = \frac{y \left[z\right]}{x \left[z\right]} = {b}_{0} + {b}_{1} {z}^{-} 1$ where ${b}_{0} = \frac{{t}_{x}}{T} ,$ ${b}_{1} = 1 - \frac{{t}_{x}}{T} ,$
*y*(*z*) = input signal in z-domain,
*x*(*z*) = linearly interpolated signal in z-domain,
*H_{L}*(*z*) = transfer function of linear interpolation in z-domain,
*T =* sampling period of *y* = *t*[*n*+1] *- t*[*n*],
*tₓ* = resampling time of *x* where 0 ≤ *tₓ* ≤ *T,*
*z = e^{-2πf_{y}T},* and
*f_{y} = frequency of input signal, y.*

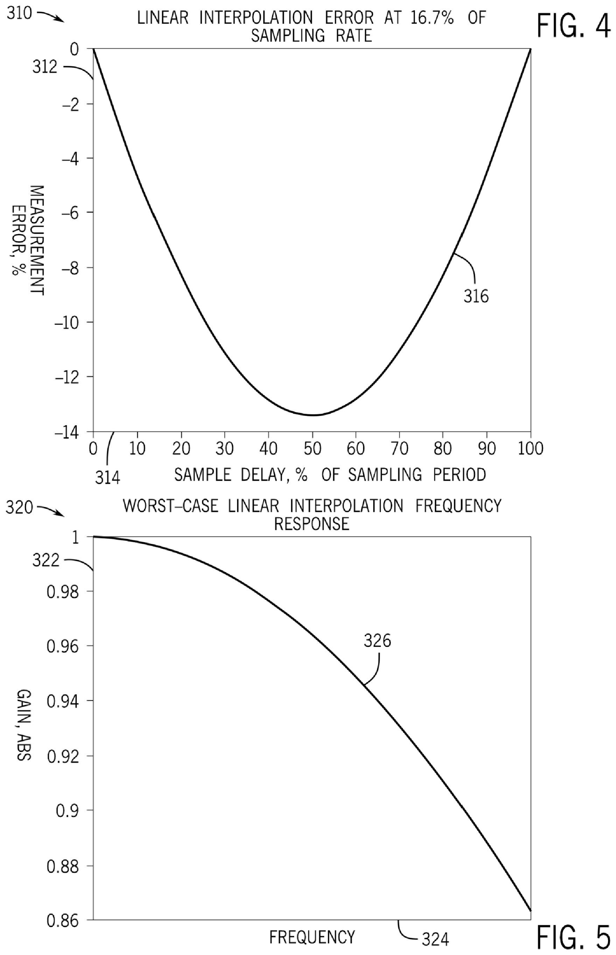

In practice, this resample point may drift between two samples. FIG. 4 illustrates a plot 310 illustrating the error induced on a resampled signal with a frequency that is approximately 16.7% of the sampling rate (e.g., 4 kHz for a 24 kHz sampling rate). An ordinate 312 represents measurement error in percentage, and an abscissa 314 represents sample delay as a percentage of the sample period. A curve 316 illustrates the error of the measured signal with respect to the sampling point as a percentage of the sampling period. The worst-case error manifests at exactly halfway between the two samples (i.e., at 50 % of the sampling period). Thus, linear interpolation in the calibration / deskew component 244 may contribute nearly 15% of magnitude error for certain frequencies (e.g., 4 kHz for a 24 kHz sampling rate).

Using this model, a plot 320 shown in FIG. 5 may be obtained to illustrate the frequency response of the linear interpolation of the calibration / deskew component 244 at the worst-case resampling time (e.g., 50% of the sampling period at a 24 kHz sampling rate). An ordinate 322 of the plot 320 represents gain in absolute terms and an abscissa 324 represents frequency from lower to higher. A curve 326 represents the frequency response of the linear interpolation of the calibration / deskew component 244. As seen in the plot 320, using linear interpolation, the calibration / deskew component 244 effectively functions as a low pass filter with increasing signal attenuation relative to increasing frequency. On its own, this interpolation method could prevent the module from measuring higher order harmonics accurately. Accordingly, the IED 200 employs several techniques to overcome these challenges.

While the plot 320 of FIG. 5 shows the worst-case error that can arise from linear interpolation, the practical implementation will produce an error that drifts between no error and worst-case error as the corresponding resample point (sample delay) drifts between 0 and 100% of the sampling period. The calibration / deskew component 244 may resample to an accurate time reference, but the modulation frequency of the IED 200 runs on its own, independent time-axis. This may produce an ever-changing or drifting sampling point between samples (e.g., the ingress sample rate may not be exactly 24 kHz, but may vary slightly). This makes that task of characterizing the calibration / deskew component 244 difficult when its "filter" characteristics are changing (i.e., *tₓ* is not a constant).

As noted above with reference to FIG. 2, one technique that may be used to address this is to use an ingress sample rate that is slightly higher than the egress sample rate (e.g., the ingress sample rate may take place at a base frequency plus some offset, while the egress sample rate may be at the base frequency). The slight difference in sampling rates effectively averages the frequency response of the calibration / deskew component 244, where the sample point may be different for each interpolation. This may result in averaging the frequency response of the interpolation, allowing the accurate characterization of the filter characteristics of the calibration / deskew component 244 with a single model.

The interpolation time (*tₓ*) that provides the average of the magnitude response of the linear interpolation model may be obtained by solving for the value of *tₓ* that produces this average. Assuming the same filter model described in previous section and a fixed input frequency for *y*, the following equation may be obtained: $\left|{H}_{L}\left({e}^{- j 2 {πf}_{y} T}\right)\right| = \left|\frac{{t}_{x}}{T}+\left.\left(1-\frac{{t}_{x}}{T}\right){e}^{- j 2 {πf}_{y} T}\right)\right|$ where *f_{y}* is the frequency of the input signal *y*. The equation above reduces to: $\left|{H}_{L}\left({e}^{- j 2 {πf}_{y} T}\right)\right| = {\left({t}_{x}^{2}\frac{2 - 2 cos \left(j2{πf}_{y}T\right)}{{T}^{2}}-{t}_{x}\frac{2 - 2 cos \left(j2{πf}_{y}T\right)}{T}+1\right)}^{1 / 2}$

Thus, the average of the magnitude response squared for all values of *tₓ* between 0 and T and for a fixed input signal frequency, *f_{y}*, can be defined as: $average \left({\left|{H}_{L}\left({e}^{- j 2 {πf}_{y} T}\right)\right|}^{2}\right) = \frac{1}{T} {\int }_{0}^{T} \left({τ}^{2}\frac{2 - 2 cos \left(j2{πf}_{y}T\right)}{{T}^{2}}-τ\frac{2 - 2 cos \left(j2{πf}_{y}T\right)}{T}+1\right) dτ$

Note that the square of the magnitude, rather than the magnitude itself, is being used, since it makes the integration much easier (removing the square root component in the integral). After performing the integration above, the average magnitude response squared in terms of the sampling period *T* and input frequency *fₓ* may be written as: $average \left({\left|{H}_{L}\left({e}^{- j 2 {πf}_{y} T}\right)\right|}^{2}\right) = \frac{2 - 2 cos \left(j2{πf}_{y}T\right)}{3} - \frac{2 - 2 cos \left(j2{πf}_{y}T\right)}{2} + T$

The solution to the equation above may be used to determine the value of tₓ that provides the average frequency response of H_{L}(z). With some symbolic substitution and simplification, this equation may be written as: ${t}_{x}^{2} \frac{c}{{T}^{2}} - {t}_{x} \frac{c}{T} + 1 = 1 - \frac{c}{6}$ where $c = 2 - 2 cos \left(j2{πf}_{y}T\right)$

The above equation can be further simplified to: $c \left({t}_{x}^{2}\frac{1}{{T}^{2}}-{t}_{x}\frac{1}{T}+\frac{1}{6}\right) = 0$

This is a quadratic equation for which the value *tₓ* may be solved using the quadratic formula. Because c can be eliminated from the above equation, *tₓ* is independent of the input signal frequency. Thus, a solution for *tₓ* is: ${t}_{x}^{2} \frac{1}{{T}^{2}} - {t}_{x} \frac{1}{T} + \frac{1}{6} = 0$ and the quadratic formula may be used to solve for *tₓ,* where ${t}_{x - avg} = \frac{\frac{1}{T} \pm \sqrt{\frac{1}{{T}^{2}} - \frac{2}{3 {T}^{2}}}}{\frac{2}{{T}^{2}}} = T \left(\frac{3 \pm √ \left(3\right)}{6}\right)$

One of the two values of *tₓ* above to create a filter that models the averaged linear interpolation: ${H}_{L - avg} \left(z\right) = \frac{{t}_{x - avg}}{T} + \left(1-\frac{{t}_{x - avg}}{T}\right) {z}^{- 1}$

The equation above is a model of the linear interpolation for all frequencies of the input signal *y* with a sample period *T.* This model may be used to generate the equivalent frequency response of the calibration / deskew component 244 and generate the gain compensation filters 240 and 242 to correct the errors introduced by linear interpolation. The gain compensation filters 240 and 242 may be formed using any suitable filter, such as a multi-tap FIR filter (e.g., a 3-tap FIR filter, 4-tap FIR filter, 5-tap FIR filter, 6-tap FIR filter, 7-tap FIR filter, 9-tap FIR filter).

To design the gain compensation filters 240 and 242, the Generalized Remez FIR filter design (FIRGR) of MATLAB by MathWorks may be used along with the inverse gain of the voltage and current channel models. These filters provide magnitude responses that align nicely with the voltage and current channels.

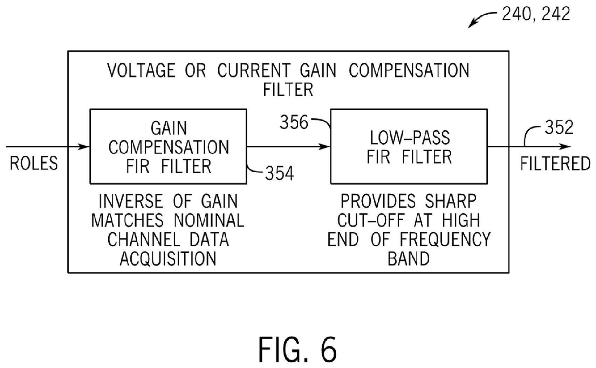

FIG. 6 illustrates a block diagram of one example of the QICF 256. Note that, in some embodiments, the gain compensation filters 240 and 242 may also use this structure. As shown in FIG. 6, digital samples may be received at an input 350 of the QICF 256. A gain compensation FIR filter 354 may compensate for attenuation due to quadratic interpolation that will be performed. Indeed, to expand measurement bandwidth, the gain compensation FIR filter 354 may be a finite impulse response (FIR) filter that "levels" or "flattens" the magnitude response and extends the effective bandwidth of the digital sampling.

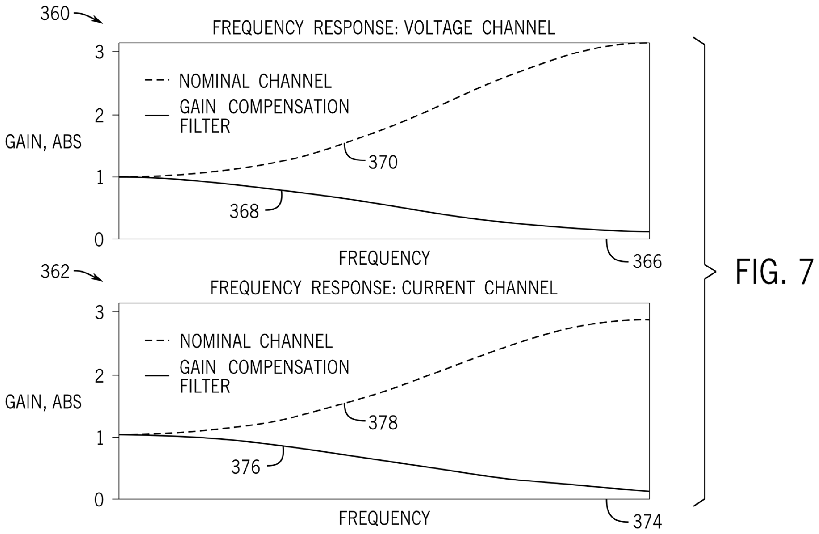

A set of plots 360 and 362 of FIG. 7 illustrate the magnitude responses of the gain compensation filters 240 and 242, respectively, as well as the nominal corresponding current and voltage channel magnitude responses for comparison. In the plot 360, an ordinate 364 represents gain in absolute terms for the voltage channel and an abscissa 366 represents frequency from lower to higher. A curve 368 represents the nominal response of the voltage channel without gain compensation and a curve 370 represents the response after applying the gain compensation filter 240. In the plot 362, an ordinate 372 represents gain in absolute terms for the current channel and an abscissa 374 represents frequency from lower to higher. A curve 376 represents the nominal response of the current channel without gain compensation and a curve 378 represents the response after applying the gain compensation filter 242. Observe that the gain response of the filters 240 and 242 closely resemble a "reflection" of each channel's gain response across the frequency axis at unity.

In some embodiments, because the gain compensation FIR filter 354 introduces large gains at higher frequencies, its impact beyond the target measurement bandwidth for PQ may be limited using a low-pass filter 356 (e.g., a low-pass FIR filter). In other embodiments, the low-pass filter 356 may not be used because later processing components may implement other low-pass filters themselves. The low-pass filter 356 may be designed to sharply cut-off at frequencies beyond the upper frequency limit. Note that FIR filters with symmetrical taps may be used, as they provide stability and linear phase responses (e.g., constant group delay), which can be corrected using the calibration / deskew component 244 or in later stages (e.g., the quantity processing stage 224). Furthermore, the gain compensation FIR filter 354 may be applied to the main processing stream, with negligible effects on downstream quantity processing.

PQ processing may use any suitable number of samples per electrical frequency cycle (e.g., 256 samples per cycle). This involves downsampling from the base frequency (e.g., 24 kHz). As such, the gain compensation filter 354 provides gain well beyond the target frequency band (e.g., 4 kHz). The gain compensation filter 354 may be designed to match the magnitude response up to the target frequency band (e.g., 4 kHz), but the gain these filters provide beyond the target frequency band (e.g., 4 kHz) is undesired for the downstream power quality resampling. As such, the low-pass 356 may remove this gain and filter out signals at frequencies beyond the target frequency band (e.g., 4 kHz). Fortunately, a relatively large-window FIR filter with a sharp, low-pass cut-off frequency may be applied to remove the undesired gain at the higher frequencies. For example, a multi-tap (e.g., 100 order (101 tap), 150 order (151 tap), 200 order (201 tap)) FIR filter with a cut-frequency of slightly higher than the target frequency band (e.g., 4.6 kHz) may be applied. Applying the low-pass filter 356 in tandem with the high-pass gain compensation filter 354 provides the desired "flat" magnitude response that is desired while maintaining the cut-off frequency to satisfy Nyquist.

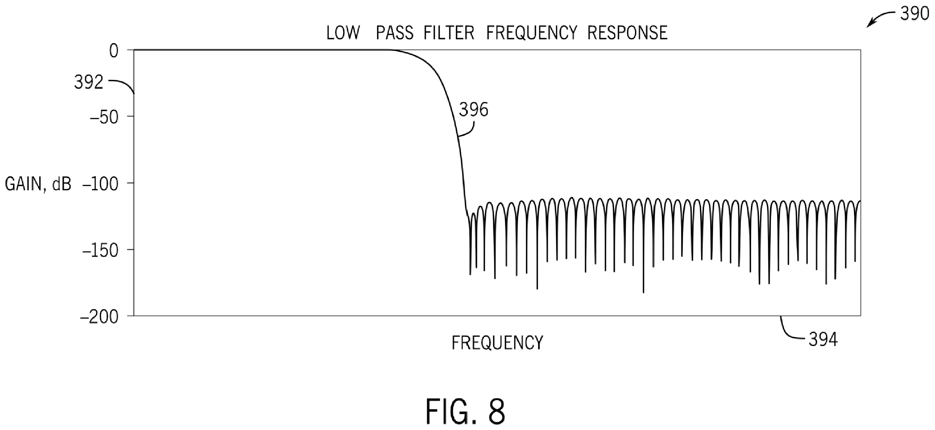

A plot 390 of FIG. 8 illustrates a frequency response of a 151-tap FIR low-pass filter that may be used as the low-pass filter 356. An ordinate 392 represents gain in units of decibels (dB) and an abscissa 394 represents frequency from lower to higher. A curve 396 represents the frequency response of the low-pass filter 356. In the plot 390, the curve 396 attenuates dramatically beyond the target frequency band (e.g., beyond 4 kHz).

In addition to filtering to ameliorate errors due to linear interpolation, the IED 200 may employ quadratic interpolation for further refinement. This is shown in may take place in the quadratic interpolation resampler 276 in the quantity processing stage 224 in FIG. 2. Quadratic interpolation provides a substantial increase in accuracy for higher frequency measurements compared to linear interpolation. The quadratic interpolation resampler 276 may obtain some number of samples per cycle (e.g., 256 samples per cycle) in the power quality processing stream to obtain excellent PQ results. Because even quadratic interpolation will include some error, however, the QICF 256 may account for such error before the quadratic interpolation resampler 276 performs this operation.

Similarly to linear interpolation, quadratic interpolation may be described in terms of an FIR filter as: ${H}_{Q} \left(z\right) = \frac{y \left[z\right]}{q \left[z\right]} = {b}_{0} + {b}_{1} {z}^{- 1} + {b}_{2} {z}^{- 2}$ where ${b}_{0} = \frac{{t}_{x} \left({t}_{x}-T\right)}{2 {T}^{2}} ,$ ${b}_{1} = - \frac{{t}_{x} \left({t}_{x}-2T\right)}{{T}^{2}} ,$ ${b}_{2} = \frac{\left({t}_{x}-T\right) \left({t}_{x}-2T\right)}{2 {T}^{2}} ,$
*y*(*z*) = input signal in z-domain,
*q*(*z*) = quadratically interpolated signal in z-domain,
*H_{Q}*(*z*) = transfer function of linear interpolation in z-domain,
*T =* sampling period of *y = t*[*n+*1] *- t*[*n*], and
*tₓ* = resampling time of *x,* where 0 ≤ *tₓ* ≤ *T.*

For comparison to the linear interpolation performance, measurement error with respect to the interpolated sample time as a percentage of the sampling period may be examined. A plot 330 of FIG. 9 illustrates the error induced on a quadratic interpolated signal with a frequency that is approximately 16.7% of the sampling rate (e.g., 4 kHz for a 24 kHz sampling rate). An ordinate 332 represents measurement error in percentage terms. An abscissa 334 represents sample delay as a percentage of the sampling period. The plot 330 of FIG. 8 includes the curve 316 representing linear interpolation error of the measured signal with respect to the sampling point as a percentage of the sampling period. A curve 336 represents quadratic interpolation error of the measured signal with respect to the sampling point as a percentage of the sampling period. As can be seen in the plot 330 of FIG. 9, the error in quadratic interpolation is than linear interpolation error by a factor of approximately five.

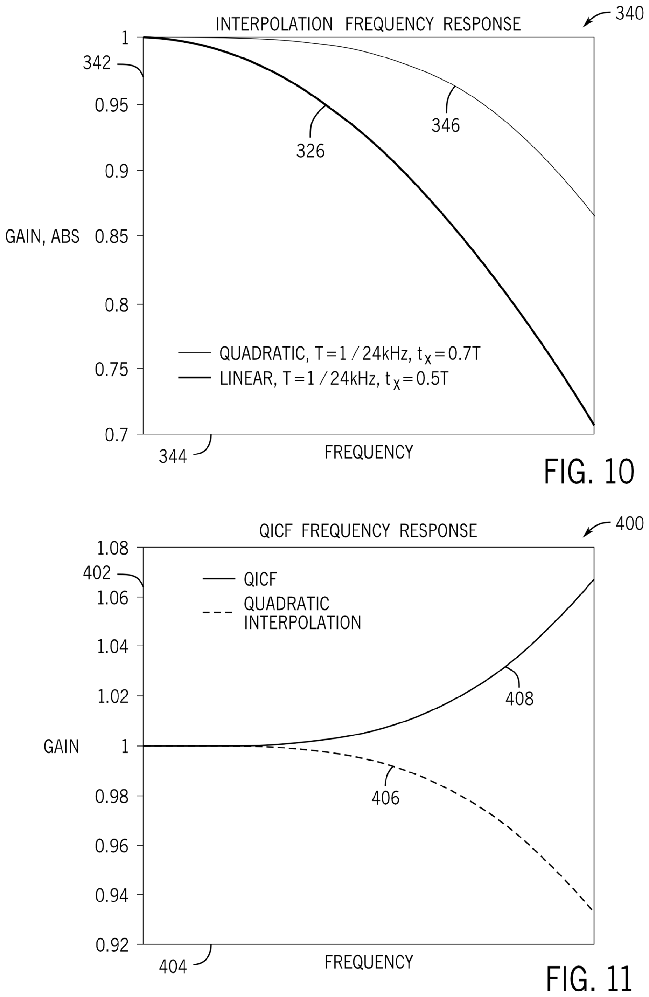

Note that the maximum quadratic interpolation error in the plot 330 occurs at 70% of the sampling period. Also observe that, while the error has been greatly reduced, there is still nearly 2% magnitude attenuation at the highest harmonic. The worst-case frequency response of the quadratic interpolation may be characterized using the FIR filter model with a fixed sample point at 70% of the sampling period. This is shown by a plot 340 of FIG. 10, which illustrates the frequency response of the quadratic interpolator with worst-case sampling delay, along with the worst-case, linear interpolation frequency response.

In the plot 340, an ordinate 342 represents gain in absolute terms and an abscissa 344 represents frequency from lower to higher. The curve 326 represents the frequency response of the linear interpolation. A curve 346 represents the frequency response of quadratic interpolation under the same conditions.

The plot 340 demonstrates that quadratic interpolation provides a dramatic improvement in measurement accuracy for higher order harmonics. However, this method would still benefit from further improvement to minimize errors and maximize accuracy for higher order harmonics. A model of the averaged quadratic filter may be derived following the same processes discussed in the previous section for linear interpolation. However, this process involves solving the roots of a fourth-order polynomial. A recursive algorithm (e.g., Newton-Raphson) may be used to find the closest root, rather than solve it directly via algebra. The square of the magnitude of the filter model of the quadratic interpolation resampler 276, given an input frequency *f_{y}*, can be written as: ${\left|{H}_{Q}\left({e}^{- j 2 {πf}_{y} T}\right)\right|}^{2} = {P}_{4} {t}_{x}^{4} + {P}_{3} {t}_{x}^{3} + {P}_{2} {t}_{x}^{2} + {P}_{1} {t}_{x} + {P}_{0}$ Where ${P}_{0} = {C}^{2} + {F}^{2} ,$ ${P}_{1} = 2 BC + 2 EF ,$ ${P}_{2} = 2 AC + {B}^{2} + 2 DF + {E}^{2} ,$ ${P}_{3} = 2 AB + 2 DE ,$ ${P}_{4} = {A}^{2} + {D}^{2}$ and $A = \frac{1 - 2 cos \left(Ω\right) + cos \left(2Ω\right)}{2 {T}^{2}} ,$ $B = \frac{4 cos \left(Ω\right) - 3 cos \left(2Ω\right) - 1}{2 T} ,$ $C = cos \left(2Ω\right) ,$ $D = \frac{2 sin \left(Ω\right) - sin \left(2Ω\right)}{2 {T}^{2}} ,$ $E = \frac{- 4 sin \left(Ω\right) + 3 sin \left(2Ω\right)}{2 T} ,$ $F = - sin \left(2Ω\right) ,$ and $Ω = 2 {πf}_{y} T .$

Using the same approach for the linear interpolation, the value of *tₓ* that produces the average of the square of the quadratic interpolation resampler 276 magnitude response may be determined. Thus, *tₓ* may be solved for given the following fourth order polynomial: ${P}_{4} {t}_{x}^{4} + {P}_{3} {t}_{x}^{3} + {P}_{2} {t}_{x}^{2} + {P}_{1} {t}_{x} + {P}_{0} = \frac{1}{T} {\int }_{0}^{T} \left({P}_{4}{τ}^{4}+{P}_{3}{τ}^{3}+{P}_{2}{τ}^{2}+{P}_{1}τ+{P}_{0}\right) dτ$

In this way, the QICF 256 may compensate for loss in gain from the quadratic interpolation that will occur when the quadratic interpolation resampler 276 downsamples to a lower sampling rate (e.g., 256 samples per cycle). In some embodiments, the QICF & LPF 256 may include a gain compensation filter followed by a separate low-pass filter. In other embodiments, the QICF & LPF 256 may include a single filter that performs both gain compensation and low-pass filtering. Using the same technique applied for gain compensation in the gain compensation filters 240 and 242 (e.g., operating on the data stream of samples having the base frequency plus the offset (e.g., 24.1 kHz when the base frequency is 24 kHz)), a multi-tap FIR filter (e.g., a 5-tap FIR filter) that matches the inverse of the averaged frequency response of the quadratic interpolation resampler may be designed. This is the QICF.

FIG. 11 provides a plot 400 showing the gain compensation provided by the QICF of the QICF & LPF 256. An ordinate 402 represents gain in absolute terms and an abscissa 404 represents frequency from lower frequency to higher frequency. A curve 406 represents the nominal result of the quadratic interpolation resampler 276 without the QICF and a curve 408 represents the result of the quadratic interpolation resampler 276 with the QICF (but without low-pass filtering).

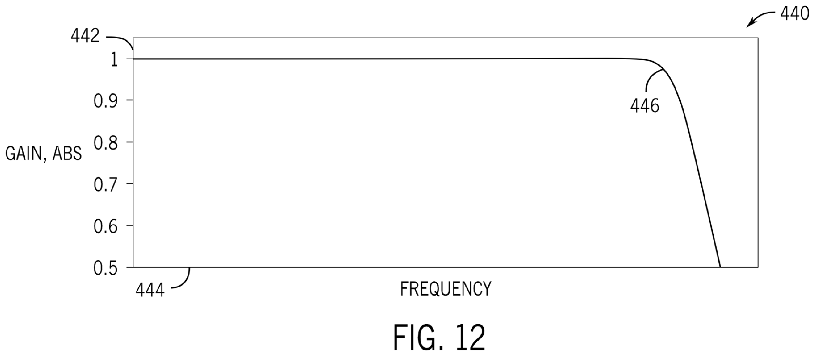

However, as mentioned above, the QICF may not be implemented directly but rather may be convolved with a low-pass filter, such as the low-pass filter discussed above to produce the QICF & LPF 256. In embodiments where the LPF has 151 taps, the single QICF & LPF 256 filter may be a single FIR filter with 155 taps. The resulting magnitude response of this filter, when combined with the effects of quadratic interpolation, is shown in a plot 440 of FIG. 12. An ordinate 442 represents gain in absolute terms and an abscissa 444 represents frequency in order of lower to higher. A curve 446 shows the frequency response of the QICF & LPF 256. As seen in FIG. 12, this filter provides excellent compensation with flat, unity gain within the desired target measurement bandwidth range (e.g., 4 kHz) and a sharp cut-off for higher frequencies.

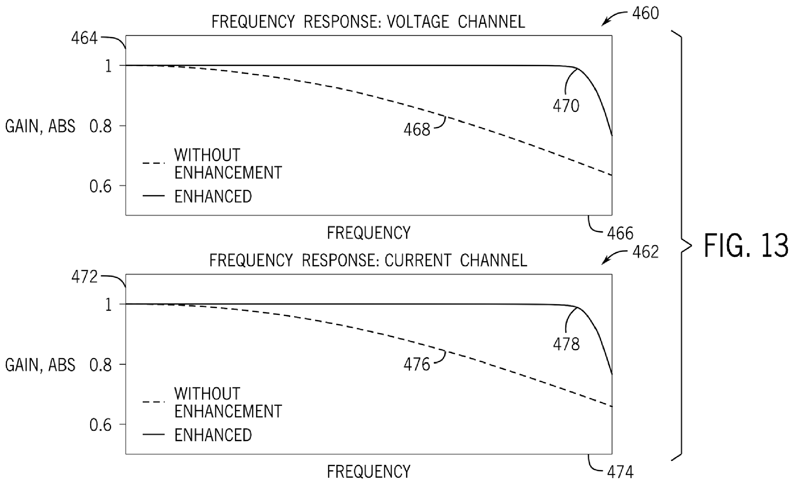

These filters may be implemented to validate effectiveness. Plots 460 and 462 of FIG. 13 show the final response of the data acquisition for voltage and current channels, respectively, after applying the compensation and low-pass filters to a 24 kHz output stream. In the plot 460, an ordinate 464 represents gain in absolute terms and an ordinate 466 represents frequency from lower to higher. A curve 468 illustrates the nominal frequency response of the voltage channel without enhancement, whereas a curve 470 illustrates the frequency response of the voltage channel with the enhancement of this disclosure. In the plot 462, an ordinate 472 represents gain in absolute terms and an ordinate 474 represents frequency from lower to higher. A curve 476 illustrates the nominal frequency response of the current channel without enhancement, whereas a curve 478 illustrates the frequency response of the current channel with the enhancement of this disclosure. The plots 460 and 462 show that the enhancements of this disclosure may provide a flat magnitude response within the desired frequency band, followed by a sharp drop immediately after reaching the target frequency (e.g., 4 kHz) as a consequence of the low-pass filter.

Some embodiments include an intelligent electronic device (IED) for an electric power delivery system, the IED comprising: analog front-end hardware configured to receive current and voltage measurements of the electric power delivery system; sampling circuitry configured to digitally sample the current and voltage measurements according to a first clock to obtain initial digital samples of the current and voltage measurements; a first resampling component configured to perform linear interpolation on the initial digital samples of the current and voltage measurements according to a second clock to obtain resampled digital samples of the current and voltage measurements; a second resampling component configured to perform quadratic interpolation on the resampled digital samples of the current and voltage measurements at a tracking frequency to obtain samples corresponding to electric power delivery harmonics for power quality; and one or more compensation filters configured to compensate for linear interpolation error or quadratic interpolation error, or both. The sampling circuitry may be configured to digitally sample the current and voltage measurements at a base frequency plus an offset frequency and the first resampling component is configured to perform linear interpolation on the initial digital samples of the current and voltage measurements at the base frequency. The offset frequency may be greater than 0.05 kHz higher than the base frequency. The one or more compensation filters may comprise one or more symmetric finite impulse response (FIR) filters. The one or more compensation filters may comprise: a first gain compensation filter configured to compensate the initial digital samples of the voltage measurement for linear interpolation introduced by the first resampling component; a second gain compensation filter configured to compensate the initial digital samples of the current measurement for linear interpolation introduced by the first resampling component. The one or more compensation filters may comprise: a first low-pass filter configured to attenuate an output of the first gain compensation filter beyond the tracking frequency; and a second low-pass filter configured to attenuate an output of the second gain compensation filter beyond the tracking frequency. The first gain compensation filter and the second gain compensation filter may be applied before the first resampling component. The one or more compensation filters may comprise a finite impulse response (FIR) filter configured to compensate for quadratic interpolation error introduced by the second resampling component. The FIR filter configured to compensate for quadratic interpolation error may comprise a single filter configured to provide gain compensation for quadratic interpolation error and low-pass filtering beneath the tracking frequency.

Some embodiments may include one or more tangible, non-transitory machine-readable media comprising instructions that, when executed by a data processing system, cause the data processing system to perform operations comprising: applying a first gain compensation filter to initial digital samples of an electric power delivery system obtained according to a first clock to preemptively compensate for a resampling error; and resampling the initial digital samples according to a second clock. The first clock may comprise a system clock of the data processing system and the second clock comprises a common time source of the electric power delivery system. The initial digital samples may be at a base frequency plus an offset frequency and the initial digital samples are resampled at the base frequency. The initial digital samples may be resampled using linear interpolation, wherein resampling error comprises linear interpolation error. The operations may comprise after resampling the initial digital samples according to the second clock, performing quadratic interpolation resampling at a target frequency to obtain measurements suitable for a power quality (PQ) quantity. The operations may comprise, after resampling the initial digital samples according to the second clock but performing quadratic interpolation resampling: applying a second gain compensation filter to preemptively compensate for a quadratic interpolation resampling error.

Some embodiments may include a data processing system; and memory comprising instructions configured to be executed by the data processing system, wherein the instructions, when executed, cause the data processing system to perform operations comprising: performing quadratic interpolation at a target frequency on a stream of digital values of electrical properties of an electric power delivery system; and applying a filter to compensate for quadratic interpolation errors to the stream of digital values of the electrical properties. The filter may be configured to compensate for quadratic interpolation errors is applied before quadratic interpolation is performed. The filter may be configured to compensate for quadratic interpolation errors comprises a finite impulse response (FIR) filter configured to apply gain compensation for quadratic interpolation errors and low-pass filtering beneath the target frequency. The operations may comprise generating the stream of digital values of electrical properties of the electric power delivery system according to a common time source based on linear interpolation of initial measurements obtained according to a local clock of the data processing system. The operations may comprise applying a filter to compensate for linear interpolation errors to the initial measurements before generating the stream of digital values of electrical properties of the electric power delivery system according to the common time source.

While specific embodiments and applications of the disclosure have been illustrated and described, it is to be understood that the disclosure is not limited to the precise configurations and components disclosed herein. For example, the systems and methods described herein may be applied to an industrial electric power delivery system or an electric power delivery system implemented in a boat or oil platform that may or may not include long-distance transmission of high-voltage power. Accordingly, many changes may be made to the details of the above-described embodiments without departing from the underlying principles of this disclosure. The scope of the present disclosure should, therefore, be determined only by the following claims.

Indeed, the embodiments set forth in the present disclosure may be susceptible to various modifications and alternative forms, specific embodiments have been shown by way of example in the drawings and have been described in detail herein. However, it may be understood that the disclosure is not intended to be limited to the particular forms disclosed. The disclosure is to cover all modifications, equivalents, and alternatives falling within the spirit and scope of the disclosure as defined by the following appended claims. In addition, the techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). For any claims containing elements designated in any other manner, however, it is intended that such elements are not to be interpreted under 35 U.S.C. 112(f).

## Claims

1. An intelligent electronic device (IED) for an electric power delivery system, the IED comprising:
analog front-end hardware configured to receive current and voltage measurements of the electric power delivery system;
sampling circuitry configured to digitally sample the current and voltage measurements according to a first clock to obtain initial digital samples of the current and voltage measurements;
a first resampling component configured to perform linear interpolation on the initial digital samples of the current and voltage measurements according to a second clock to obtain resampled digital samples of the current and voltage measurements;
a second resampling component configured to perform quadratic interpolation on the resampled digital samples of the current and voltage measurements at a tracking frequency to obtain samples corresponding to electric power delivery harmonics for power quality; and
one or more compensation filters configured to compensate for linear interpolation error or quadratic interpolation error, or both.

2. The IED of claim 1, wherein the sampling circuitry is configured to digitally sample the current and voltage measurements at a base frequency plus an offset frequency and the first resampling component is configured to perform linear interpolation on the initial digital samples of the current and voltage measurements at the base frequency.

3. The IED of claim 1, wherein the offset frequency is greater than 0.05 kHz higher than the base frequency.

4. The IED of claim 1, wherein the one or more compensation filters comprise one or more symmetric finite impulse response (FIR) filters.

5. The IED of claim 1, wherein the one or more compensation filters comprise:
a first gain compensation filter configured to compensate the initial digital samples of the voltage measurement for linear interpolation introduced by the first resampling component;
a second gain compensation filter configured to compensate the initial digital samples of the current measurement for linear interpolation introduced by the first resampling component.

6. The IED of claim 5, wherein the one or more compensation filters comprise:
a first low-pass filter configured to attenuate an output of the first gain compensation filter beyond the tracking frequency; and
a second low-pass filter configured to attenuate an output of the second gain compensation filter beyond the tracking frequency.

7. The IED of claim 5, wherein the first gain compensation filter and the second gain compensation filter are applied before the first resampling component.

8. The IED of claim 1, wherein the one or more compensation filters comprise a finite impulse response (FIR) filter configured to compensate for quadratic interpolation error introduced by the second resampling component.

9. The IED of claim 8, wherein the FIR filter configured to compensate for quadratic interpolation error comprises a single filter configured to provide gain compensation for quadratic interpolation error and low-pass filtering beneath the tracking frequency.

10. One or more tangible, non-transitory machine-readable media comprising instructions that, when executed by a data processing system, cause the data processing system to perform operations comprising:
applying a first gain compensation filter to initial digital samples of an electric power delivery system obtained according to a first clock to preemptively compensate for a resampling error; and
resampling the initial digital samples according to a second clock.

11. A system comprising:
a data processing system; and
memory comprising instructions configured to be executed by the data processing system, wherein the instructions, when executed, cause the data processing system to perform operations comprising:
performing quadratic interpolation at a target frequency on a stream of digital values of electrical properties of an electric power delivery system; and
applying a filter to compensate for quadratic interpolation errors to the stream of digital values of the electrical properties.

12. The system of claim 11, wherein the filter configured to compensate for quadratic interpolation errors is applied before quadratic interpolation is performed.

13. The system of claim 11, wherein the filter configured to compensate for quadratic interpolation errors comprises a finite impulse response (FIR) filter configured to apply gain compensation for quadratic interpolation errors and low-pass filtering beneath the target frequency.

14. The system of claim 11, wherein the operations comprise:
generating the stream of digital values of electrical properties of the electric power delivery system according to a common time source based on linear interpolation of initial measurements obtained according to a local clock of the data processing system.

15. The system of claim 14, wherein the operations comprise:
applying a filter to compensate for linear interpolation errors to the initial measurements before generating the stream of digital values of electrical properties of the electric power delivery system according to the common time source.
